# EUROPEAN PATENT SPECIFICATION

(11) **EP 0 443 575 B1**
(45) Date of publication and mention of the grant of the patent: **19.04.1995**
(21) Application number: 91102533.6
(22) Date of filing: 21.02.1991
(51) Int. Cl.: H01L 21/3205, H01L 23/525

(54) **Method for producing a semiconductor device**
Verfahren zur Herstellung einer Halbleitervorrichtung
Procédé de fabrication d'un dispositif semi-conducteur

(30) Priority: 21.02.1990 JP 40008/90
(43) Date of publication of application: 28.08.1991
(73) Proprietor: NIPPONDENSO CO., LTD., Kariya-shi Aichi-ken (JP)
(72) Inventor: Isobe, Yoshihiko, Toyoake-shi, Aichi (JP); Iida, Makio, Ichinomiya-shi, Aichi (JP); Miura, Shoji, Anjo-shi, Aichi (JP); Kajiura, Keizou, Nagoya-shi, Aichi (JP); Suzuki, Mikimasa, Toyohashi-shi, Aichi (JP); Saito, Masami, Kariya-shi, Aichi (JP)
(74) Representative: KUHNEN, WACKER & PARTNER

(56) References cited:
- EP-A- 0 350 961
- US-A- 4 665 295
- THIN SOLID FILMS. vol. 182, no. 1, 20 December 1989, LAUSANNE CH pages 23 -33; V. SCHULTZE ET AL: 'Laser trimming of NiCr thin film resistors. I: thinfilm resistors without a protective layer'
- THIN SOLID FILMS. vol. 182, no. 1, 20 December 1989, LAUSANNE CH pages 35 -
- 45; A. FISCHER ET AL: 'Laser trimming of NiCr thin film resistors. II: thinfilm resistors with an SiO2 protective layer'

## Description

### BACKGROUND OF THE INVENTION

### 1. Field of the Invention

The present invention relates to a method for producing a semiconductor device, and particularly to a method for producing a semiconductor device having a thin-film resistor to be trimmed by laser.

### 2. Description of the Related Art

In an insulation film of a semiconductor device having an integrated circuit, there is arranged a metallic thin-film resistor. The thin-film resistor is fused at a predetermined location by laser beam to adjust the resistance value thereof.

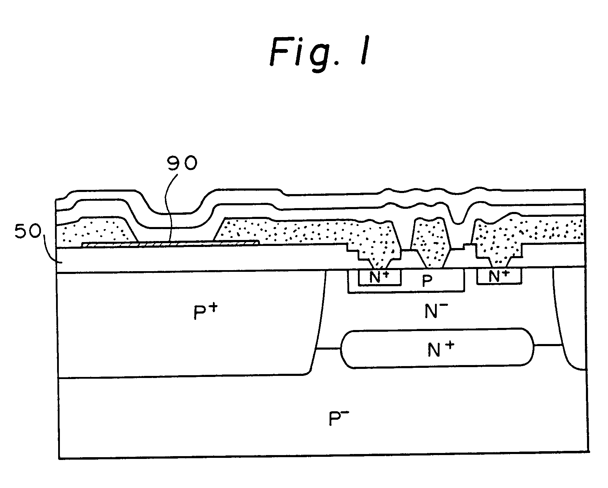

Figure 1 shows a conventional semiconductor device comprising an integrated circuit. In the figure, a field insulation film 50 is formed on the surface of a semiconductor substrate in a process in which a PN junction region for circuit elements is formed. A thin-film resistor 90 is formed on the field insulation film 50.

A process of adjusting the resistance value of the thin-film resistor 90 is called laser trimming. Thin Solid Films, Vol. 20, No. 1, pages 23-33 and 35-45, 1989 discuss laser trimming of NiCr thin film resistors. An important thing for the laser trimming is to adjust a quantity of laser energy to be absorbed by the thin-film resistor 90 to an optimum level. If the absorbed energy is too little, the thin-film resistor will fuse insufficiently, and if it is excessive, the insulation film 50 and semiconductor substrate will be damaged.

Laser beams transmitted onto the thin-film resistor are partly reflected by the lower face of the thin-film resistor and by the surface of the semiconductor substrate, and the reflected beams interfere with other transmitted beams and are absorbed by the thin-film resistor. Also, the laser beams are reflected by the surface of the thin-film resistor and by the surface of a passivation film and interfere with one another, so that a total quantity of laser beams absorbed by the thin-film resistor depends on the thicknesses of the respective films. When the thickness of the insulation film disposed between the semiconductor substrate and the thin-film resistor changes, the quantity of energy absorbed by the thin-film resistor changes greatly.

It may be possible to actually measure the thickness of the field insulation film for every wafer or every lot and control the strength of laser beams. This, however, complicates the processes.

As mentioned before, when the thin-film resistor is formed on the semiconductor substrate having the integrated circuit, an emitted laser beam is partly absorbed by the surface of the semiconductor substrate to damage the same. Also, laser beams repeatedly reflected by respective interfaces may influence a region of the integrated circuit to change electrical characteristics such as a leakage current at a PN junction.

### SUMMARY OF THE INVENTION

To solve the problems, an object of the present invention is to provide a method of producing a semiconductor device having a laser-trimmed thin-film resistor of good yield.

The present invention provides a method of producing a semiconductor device comprising the steps of forming a first insulation film on the surface of a semiconductor substrate, selectively removing an area of the first insulation film and forming a second insulation film on the surface of the semiconductor substrate thus exposed, the thickness of the second insulation film being thinner than that of the first insulation film, forming a thin-film resistor on the surface of the second insulation film, forming a passivation film on the surface of the thin-film resistor, and trimming the thin-film resistor by laser, thereby setting the resistance of the thin-film resistor.

### BRIEF DESCRIPTION OF THE DRAWINGS

Fig. 1 is a sectional view showing a semiconductor device having a thin-film resistor according to a prior art;
Figs. 2 to 8 are views showing a sequence of processes of producing a semiconductor device according to the method of the present invention, in which Fig. 8 particularly shows an example of the semiconductor device produced by the method of the present invention; and
Figs. 9 to 11 are characteristic curves showing relations between film thicknesses and laser radiation energy of semiconductor devices produced according to the present invention.

### DESCRIPTION OF THE PREFERRED EMBODIMENTS

In order to attain the object of the present invention, inventors of the present invention tried various ways for controlling a thickness of the field insulating film and met several problems in each way.

For example, in forming the thin-film resistor on the semiconductor substrate having the integrated circuit, it is, therefore, necessary to control the thickness of the field insulation film as accurately as possible to prevent the quantity of energy absorbed by the thin-film resistor from changing. The field insulation film is, however, thick (usually 0.5 micrometer or greater) so that the absolute value of a change to occur in the film thickness may become inevitably larger. The thickness of the field insulation film also increases through various high-temperature processes to be done after the formation of the field insulation film, or decreases through an etching process to be done after the formation of the field insulation film. Namely, the processes to be done before the thin-film resistor is formed on the field insulation film, change the thickness of the field insulation film. It is, therefore, very difficult to control the thickness of the field insulation film.

A semiconductor device produced according to the method of the present invention basically has the above-mentioned technical aspects. The first insulation film of the semiconductor device is preferably a field insulation film, and the second insulation film is, for example, a thermally-oxidized film such as a thermally-oxidized silicon film. Instead of the thermally-oxidized silicon film, the second insulation film may be a CVD-oxidized film. The thermally-oxidized silicon film is fine and it is easy to accurately control its thickness.

According to the preferred embodiment of the present invention, the thickness of the second insulation film is 0.1 micrometer or greater and thinner than the first insulation film. If the thickness of the second insulation film is thinner than 0.1 micrometer, fused and scattering particles of the thin-film resistor may break through the second insulation film to destroy insulation. If the thickness of the second insulation film is greater than that of the first insulation film, an absolute quantity of fluctuation of film thickness may become larger even if a rate of the fluctuation is constant.

According to experiments with a laser wavelength of 1.06 micrometers, it was found that an energy absorbing rate of the second insulation film made of a thermally-oxidized silicon film was good when its film thickness was in a range from about 0.1 to 0.3 micrometer.

According to the present invention, an area of an existing first insulation film such as a field insulation film of a semiconductor device is selectively removed to expose the surface of a semiconductor substrate where a second insulation film is to be formed to have a film thickness thinner than that of the first insulation film.

This arrangement can reduce fluctuations of the second insulation film, and selecting an optimum thickness of the second insulation film can adjust energy to be absorbed by a thin-film resistor formed on the second insulation film. Consequently, the arrangement can reduce a quantity of laser radiation, thereby reducing energy absorbed by peripheral areas such as the semiconductor substrate, and preventing a withstand voltage of the second insulation film and the electric characteristics of adjacent circuit elements such as a leakage current value of a PN junction from deteriorating.

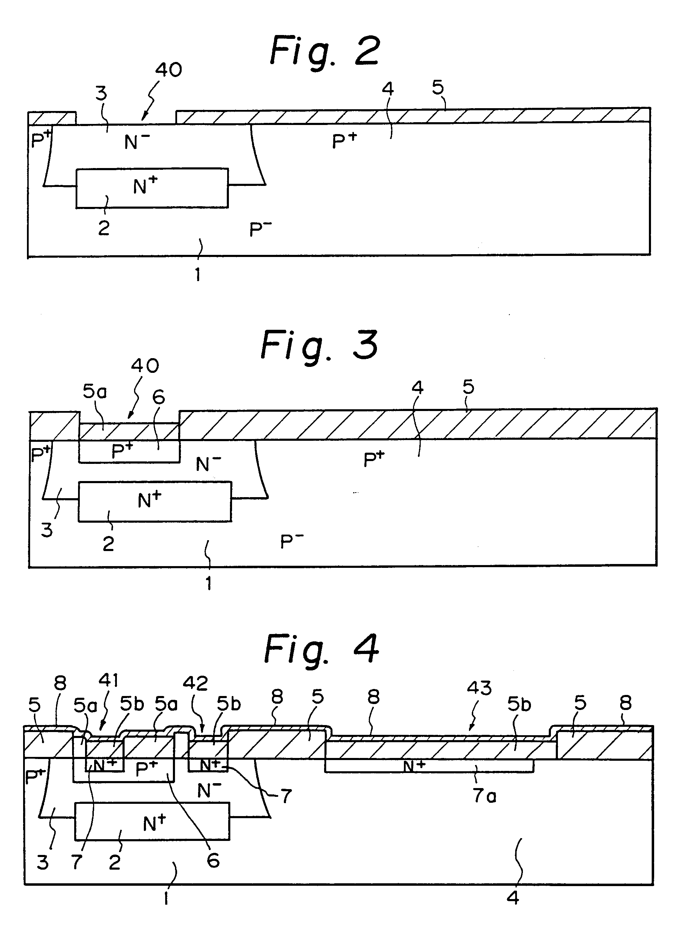

A sequence of processes of producing the semiconductor device according to the present invention will be explained with reference to Figs. 2 to 8 in which a thin-film resistor and a bipolar transistor are integrated together.

Firstly, on a crystal plane (111) of a P⁻ silicon substrate 1, there are formed an N⁺ buried diffusion region 2, an N⁻ epitaxial layer 3, and a P⁺ isolation region 4 according to a known method in which, for example, Sb is partially diffused in a part of a P-type silicon substrate to form an embedded N⁺ type diffusion region 2 then N⁻ epitaxial layer 3 is epitaxially grown in a Si atmosphere including P therein and after that, B is selectively diffused in the substrate to form a P⁺ type isolation region 4. A silicon oxide film, etc., (not shown) on the surface of the silicon substrate 1 are entirely removed, and a silicon oxide film 5 serving as a field insulation film is formed according to a thermal oxidation method to a thickness of 0.6 micrometer. An area of the silicon oxide film 5 is selectively removed to form an opening 40 as shown in Fig. 2.

Boron is ion-implanted through the opening 40, and then utilizing a CVD method, a silicon oxide film 5a serving as the field insulation film is formed in the opening 40 to a thickness of 6000 angstroms thereafter the material is heat-treated in an atmosphere of O₂ and N₂ to form a P⁺ diffusion region (base region) 6 as shown in Fig. 3.

In this process, when a new silicon oxide film 5a is formed, the silicon oxide film 5 which is previously formed on the surface of the substrate has a thickness of 1.2 »m.

Predetermined regions 41, 42, and 43 are opened through the silicon oxide films 5 and 5a, and phosphorus is doped in a diffusion furnace with POCl₂ serving as an impurity source. The material is then heat-treated in an atmosphere of O₂ and N₂ to form N⁺ diffusion regions (emitter and collector regions) 7, an N⁺ diffusion region 7a, a silicon oxide film 5b and a PSG film 8 as shown in Fig. 4. The PSG film 8 forms part of the field insulation film.

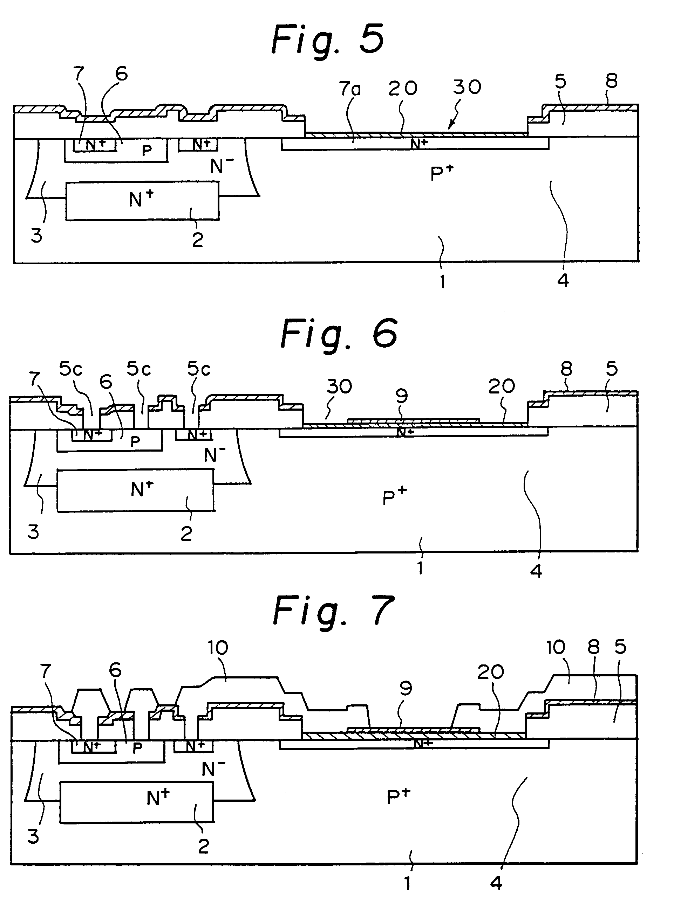

An opening 30 is formed at a predetermined position of the field insulation film 5 where a thin-film resistor 9 is to be formed. In an oxidizing atmosphere in a diffusion furnace, a silicon oxide film (the second insulation film of the present invention) 20 is formed in the opening 30 as shown in Fig. 5. The reason why the opening 30 is formed at the N⁺ diffusion layer 7a is to simultaneously form capacitors between the N⁺ diffusion layer 7a and aluminum wiring and between the N⁺ diffusion layer 7a and the thin-film resistor.

A Cr-Si layer is deposited using a sputtering method with a target including Cr and Si therein, RF-power of 280 W and Ar flow-rate of 30 secM in 5 m Torr (1 Torr ≡ 133.3 Pa) and selectively etched utilizing a photolithographic method and wet etching method to form the thin-film resistor 9 of 150 angstroms in thickness on the thermally-oxidized silicon film. Further, contact holes 5c are formed through the silicon oxide films 5a and 5b and the PSG film 8 as shown in Fig. 6.

An aluminum wiring layer 10 is formed according to the sputtering method, selectively etched to remove unnecessary parts to form a predetermined pattern, and sintered in H₂N₂ forming gas for 30 minutes at 450°C. The aluminum wiring layer 10 electrically connects the collector region of a bipolar transistor to the thin-film resistor 9 as shown in Fig. 7.

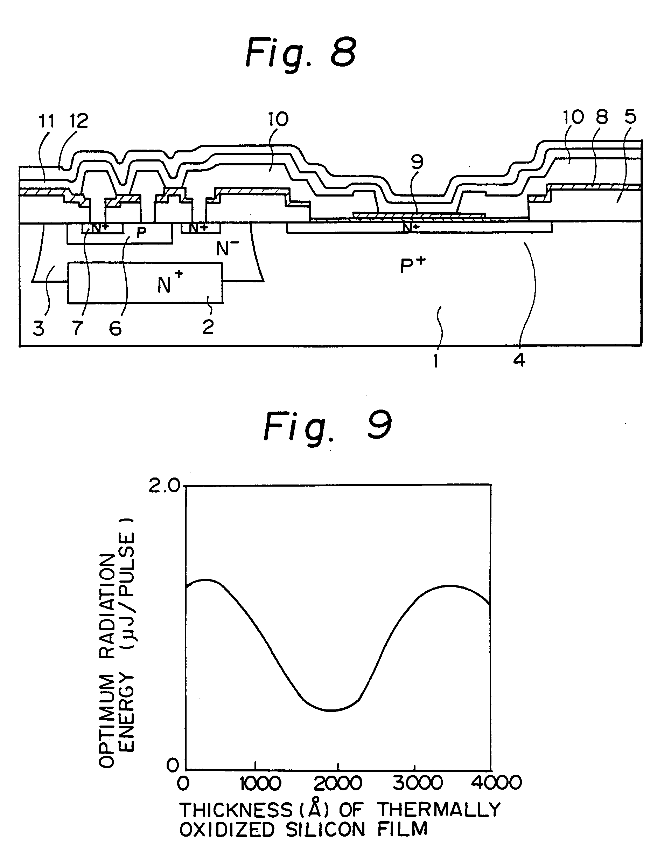

A PSG film (the passivation film of the present invention) 11 is formed using an atmospheric pressure CVD method or plasma CVD method to a thickness of 0.4 micrometer. Thereafter, a silicon nitride film (the passivation film of the present invention) 12 is formed according to the plasma CVD method to a thickness of 0.5 micrometer as shown in Fig. 8.

As explained above, the thickness of the second insulation film produced according to the embodiment is determined by the thermal oxidation process of the silicon substrate 1 as shown in Fig. 6, so that the film thickness may be very easily controllable. For example, a film thickness of 2000 angstroms that is appropriate for trimming the thin-film resistor can be formed with an allowance of less than plus or minus 100 angstroms.

The thickness of the thermally-oxidized silicon film 20 is selected to reduce laser trimming energy to as small as possible. Namely, the thickness of the film 20 is selected to increase the energy absorption rate of the thin-film resistor 9. If the laser radiation energy can be reduced, it is possible to reduce a quantity of energy to be absorbed by the silicon substrate.

Figure 9 shows a relationship between film thickness of the thermally-oxidized silicon film 20 and optimum quantity of radiation energy necessary for trimming the thin-film resistor 9 of the semiconductor device produced according to the method of the present invention. It is understood from the figure that the optimum radiation energy is minimal when the film thickness is about 0.2 micrometer.

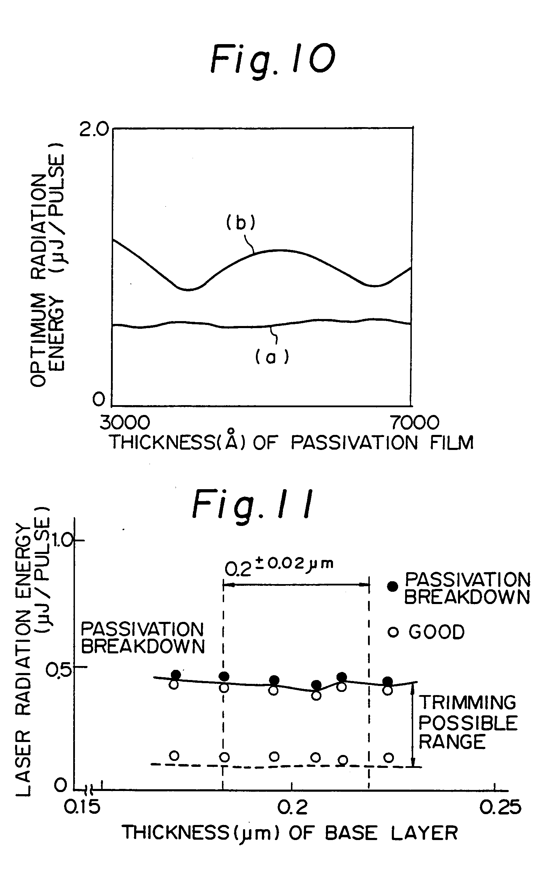

Figure 10 shows a relationship between thicknesses of the passivation films 11 and 12 and optimum radiation energy quantities. In Fig. 10, a curve (a) is for the thermally-oxidized silicon film 20 having a thickness of 0.20 plus or minus 0.02 micrometer, and a curve (b) is for the thermally-oxidized silicon film 20 having a thickness of 0.28 micrometer.

As is apparent in Fig. 10, when the thermally-oxidized silicon film 20 is 0.20 plus or minus 0.02 micrometer in thickness, an influence of fluctuations in the thicknesses of the passivation films 11 and 12 is substantially negligible. When the thickness of the thermally-oxidized silicon film 20 is less than 0.10 micrometer, the thin-film resistor 9 may disperse by about 1000 angstroms in thickness at the time of laser trimming. This is not preferable. If the film thickness is substantially equal to that of the field insulation film, it is also not preferable because a long oxidation time is needed which has a negative influence circuit elements and deteriorates film thickness controllability.

Oxidizing conditions of the silicon film 20 must be determined by considering the film thickness controllability, oxidized film growing speed, and influence on the diffusion layer. A preferable technique is a wet oxidation method carried out in a temperature range from 800 to 1000 degrees centigrade, more preferably at a temperature of 860 degrees centigrade.

As an oxidized film forming method for a Cr-Si base layer, any kind of film forming method having a capability of performance to form an oxidized film having a thickness of about 2000 ±200 Å, by which a superior evenness of the film thickness and a superior controlling ability of the film thickness can be obtained, can be used to this process.

Under the present circumstances, a thermal oxidizing method can provide such superior evenness of the film thickness and a superior controlling ability of the film thickness.

Nevertheless, this method is hardly applied to the present invention since under the method as mentioned above, i.e., a dry oxidizing method, a film forming speed is generally slow naturally to require a treatment under a high temperature or prolonged treatment.

On the other hand, a wet oxidizing method is considered to be the most suitable oxidizing method to the present invention, since the oxidized film forming speed under the wet oxidizing method, is faster than that of the dry oxidizing method and the oxidized film in the wet oxidizing method can be formed under a relatively lower temperature and in shorter period than that of the dry oxidizing method.

Further, even under a conventional CVD method, a SiO₂ film which is deposited and formed by a LPCVD method under a low pressure (for example, 1 to 10 Torr) and at a high temperature (for example, 800 to 1000°C), has a superior film thickness controlling ability and a superior film thickness and thus it can be used as an oxidized film forming method in the present invention.

Figure 11 is a view showing a relationship between laser pulse energy for enabling trimming and thickness of the thermally-oxidized silicon film 20.

In the present invention, when the thin-film resistor 9 is trimmed by utilizing a pulse laser, a cut portion is naturally formed on a part of the thin-film resister 9 causing the cross-sectional area thereof to be reduced or the width thereof to be narrowed and further, an area in which components of the thin-film resistor 9 are dispersed, is formed in the vicinity of the cut portion.

A range of the laser pulse energy for enabling trimming, i.e., the maximum and minimum values of the laser pulse energy for enabling trimming are substantially constant when the thickness of the thermally-oxidized silicon film 20 is in a range of 0.2 plus or minus 0.02 micrometer. With this range of thickness, stabilized laser trimming can be done.

In the above embodiment, the thin-film resistor 9 is formed over the N⁺ diffusion region 7a. The position of the thin-film resistor 9 is optional if it is insulated from the silicon substrate.

The thin-film resistor 9 may be made of resistance material such as Cr-Si and Ni-Cr.

The second insulation film may be not only the thermally-oxidized silicon film 20 but also a CVD-oxidized silicon film.

In the above embodiment, the laser is a YAG (Yttrium, Aluminum, Garnet) pulse laser having a wavelength of 1.06 micrometers. This wavelength is optional according to the present invention. For example, a YLF (Yttrium, Lithium, Fluorine) laser having a wavelength of 1.047 micrometers can be employed. Namely, a wavelength in a range from 1.047 to 1.06 micrometers is usable.

When YAG pulse laser is used, the wave form as shown in Fig. 9 which is obtained when YLF pulse laser is used, is slightly shifted parallely to a direction to which the thickness of the film is reduced, by around 100 Å.

Therefore, a most suitable film thickness formed utilizing the YAG pulse laser is 1900 ±200 Å.

As explained above, according to the method of producing the semiconductor device of the present invention, a first insulation film is formed on a semiconductor substrate having circuit elements. An area of the first insulation film is selectively removed and a second insulation film that is thinner than the first insulation film is formed on the semiconductor substrate surface thus exposed. A thin-film resistor is formed on the surface of the second insulation film. This arrangement can remarkably reduce fluctuations in the thickness of the second insulation film, thereby reducing fluctuations in energy absorbed by the thin-film resistor.

The present invention can, therefore, solve the problems of inferior fusion of the thin-film resistor and the cracking of the insulation film, thereby remarkably improving yield.

For example, when the first insulation film is a field insulation film, the second insulation film on which the thin-film resistor is to be formed is formed after selectively removing the first insulation film and exposing the surface of the semiconductor substrate, so that the formation of the second insulation film may never require complicated processes such as those required in forming the first insulation film. This drastically reduces fluctuations of the thickness of the insulation film and fluctuations of energy absorbed by the thin-film resistor. The thickness of the second insulation film may be so set to improve a laser energy absorption rate of the thin-film resistor and to reduce the influence of other factors such as passivation films that affect the laser absorption rate, thereby stably trimming the thin-film resistor by laser.

A thin-film resistor produced by the process of the present invention has a configuration such that it has a cut-end portion and a cross-sectional area thereof is smaller than that of the rest portion of the thin film resistor and at least a portion of components of the thin film resistor are dispersed into at least one of the second insulation film and the passivation film which contacts to a vicinity of the cut-end portion of the thin film resistor causing to make an area in the resistor in a vicinity of the cut-end portion, in which an amount of the components of the thin film resistor is reduced.

## Claims

1. A method of producing a semiconductor device, comprising the steps of:
forming a first insulation film on the surface of a semiconductor substrate;
selectively removing an area of the first insulation film and forming a second insulation film on the surface of the semiconductor substrate thus exposed, the thickness of the second insulation film being thinner than that of the first insulation film;
forming a thin-film resistor on the surface of the second insulation film;
forming a passivation film on the surface of the thin-film resistor; and
trimming the thin-film resistor by laser, thereby setting the resistance value of the thin-film resistor.

2. A method as set forth in claim 1, wherein semiconductor elements are formed in advance in an element region on the surface of the semiconductor substrate said element region being located in an area other than that where the resistor is to be formed.

3. A method as set forth in claim 1, wherein said thin-film resistor is mainly made of Cr-Si or Ni-Cr.

4. A method as set forth in claim 1, wherein said second insulation film is a thermally-oxidized film.

5. A method as set forth in claim 1, wherein the thickness of said second insulation film is in a range from 0.1 to 0.3 micrometer.

6. A method as set forth in claim 1, wherein the thickness of said second insulation film is 0.2 plus or minus 0.02 micrometer.

7. A method as set forth in claim 1, wherein said second insulation film is formed according to a wet oxidation method.

8. A method as set forth in claim 1, wherein the wavelength of the laser used for trimming the thin-film resistor is in a range from 1.047 to 1.06 micrometers.

9. A method as set forth in claim 1, wherein the laser is a YAG pulse laser or a YLF pulse laser.

## Patentansprüche

1. Verfahren zum Herstellen einer Halbleitervorrichtung, mit den folgenden Schritten:
Ausbilden eines ersten Isolationsfilms auf der Oberfläche eines Halbleitersubstrats;
selektives Entfernen einer Fläche des ersten Isolationsfilms und Ausbilden eines zweiten Isolationsfilms auf der Oberfläche des so freigelegten Halbleitersubstrats, wobei die Dicke des zweiten Isolationsfilms dünner als die des ersten Isolationsfilms ist;
Ausbilden eines Dünnschicht-Widerstands auf der Oberfläche des zweiten Isolationsfilms;
Ausbilden eines Passivierungsfilms auf der Oberfläche des Dünnschicht-Widerstands; und
Abgleichen des Dünnschicht-Widerstands durch einen Laser, wodurch der Widerstandswert des Dünnschicht-Widerstands eingestellt wird.

2. Verfahren nach Anspruch 1, bei dem Halbleiterelemente im voraus in einem Elementbereich auf der Oberfläche des Halbleitersubstrats ausgebildet werden, wobei der Elementbereich auf einer anderen Fläche angeordnet ist, als die auf der der Widerstand ausgebildet ist.

3. Verfahren nach Anspruch 1, bei dem der Dünnschicht-Widerstand hauptsächlich aus Cr-Si oder Ni-Cr hergestellt ist.

4. Verfahren nach Anspruch 1, bei dem der zweite Isolationsfilm ein thermisch oxidierter Film ist.

5. Verfahren nach Anspruch 1, bei dem sich die Dicke des zweiten Isolationsfilms in einem Bereich von 0.1 bis 0.3 Mikrometer befindet.

6. Verfahren nach Anspruch 1, bei dem die Dicke des zweiten Isolationsfilms plus oder minus 0.02 Mikrometer beträgt.

7. Verfahren nach Anspruch 1, bei dem der zweite Oxidationsfilm gemäß einem Naßoxidationsverfahren ausgebildet wird.

8. Verfahren nach Anspruch 1, bei dem sich die Wellenlänge des zum Abgleichen des Dünnschicht-Widerstands verwendeten Lasers in einem Bereich von 1.047 bis 1.06 Mikrometer befindet.

9. Verfahren nach Anspruch 1, bei dem der Laser ein YAG-Pulslaser oder ein YLF-Pulslaser ist.

## Revendications

1. Procédé de fabrication d' un dispositif semi - conducteur , comprenant les étapes consistant à :
former un premier film isolant sur la surface d' un substrat semi - conducteur ;
retirer sélectivement une surface du premier film isolant, puis à former un second film isolant sur la surface du substrat semi - conducteur ainsi exposée, l' épaisseur du second film isolant étant plus faible que celle du premier film isolant ;
former une résistance en film mince sur la surface du second film isolant ;
former un film passivant sur la surface de la résistance en film mince ; et
ajuster finement la résistance en film mince par laser, fixant ainsi la valeur de résistance de la résistance en film mince .

2. Procédé comme exposé dans la revendication 1 , dans lequel des éléments semi - conducteurs sont formés sur la surface du substrat semi - conducteur dans une région d' éléments , la dite région d' éléments étant située dans une région autre que celle où la résistance doit être formée .

3. Procédé comme exposé dans la revendication 1 , dans lequel la dite résistance en film mince est constituée principalement de Cr-Si ou de Ni-Cr .

4. Procédé comme exposé dans la revendication 1 , dans lequel le dit second film isolant est un film oxydé thermiquement .

5. Procédé comme exposé dans la revendication 1 , dans lequel l' épaisseur du dit second film isolant est comprise entre 0,1 et 0,3 micromètres .

6. Procédé comme exposé dans la revendication 1 , dans lequel l' épaisseur du dit second film isolant est 0,2 plus ou moins 0,02 micromètres .

7. Procédé comme exposé dans la revendication 1, dans lequel le dit second film isolant est formé selon une méthode d' oxydation par voie humide .

8. Procédé comme exposé dans la revendication 1 , dans lequel la longueur d' onde du laser utilisé pour ajuster finement la résistance en film mince est comprise entre 1,047 et 1,06 micromètres .

9. Procédé comme exposé dans la revendication 1 , dans lequel le laser est un laser YAG à impulsions ou un laser YLF à impulsions.
